# EUROPEAN PATENT SPECIFICATION

(11) **EP 3 206 466 B1**
(45) Date of publication and mention of the grant of the patent: **08.04.2020**
(21) Application number: 17155422.3
(22) Date of filing: 09.02.2017
(51) Int. Cl.: H05K 5/00, H05K 5/02

(54) **THERMOSTAT WITH UNIVERSAL WALL MOUNTABLE CONNECTOR**
THERMOSTAT MIT UNIVERSELLEM WANDEINBAUVERBINDER
THERMOSTAT AVEC CONNECTEUR MURAL UNIVERSEL

(30) Priority: 12.02.2016 US 201662294911 P
(43) Date of publication of application: 16.08.2017
(73) Proprietor: Honeywell International Inc., Morris Plains, NJ 07950 (US)
(72) Inventor: READ, Travis, Morris Plains, NJ 07950 (US); EMMONS, David J., Morris Plains, NJ 07950 (US); GILMER, Preston, Morris Plains, NJ 07950 (US); AMUNDSON, John B., Morris Plains, NJ 07950 (US); FINCH, Heidi, deceased (US); BARTON, Eric, Morris Plains, NJ 07950 (US); SAPAK, Jiri, Morris Plains, NJ 07950 (US); KHOURY, Tarik, Morris Plains, NJ 07950 (US); WOLFF, Steven L., Morris Plains, NJ 07950 (US); GRAY, James, Morris Plains, NJ 07950 (US)
(74) Representative: Houghton, Mark Phillip

(56) References cited:
- EP-A2- 1 113 713
- US-A1- 2008 013 259
- US-A1- 2010 256 788
- US-A1- 2014 321 011

## Description

### Technical Field

The present disclosure pertains to Heating, Ventilation, and/or Air Conditioning (HVAC) systems. More particularly, the present disclosure pertains to HVAC controllers, such as thermostats, and devices for mounting such HVAC controllers to a wall.

### Background

Heating, Ventilation, and/or Air Conditioning (HVAC) systems are often used to control the comfort level within a building or other structure. Such HVAC systems typically include an HVAC controller that controls various HVAC components of the HVAC system in order to affect and/or control one or more environmental conditions within the building. In many cases, the HVAC controller is mounted to an internal wall of the building and provides control signals to various HVAC components of the HVAC system, sometimes via a number of control wires that extend through the wall. In some cases, the HVAC controller includes an HVAC controller head unit and a wall plate. During installation, the wall plate is typically mounted to an internal wall of the building, and the HVAC controller head unit is removably mounted to the wall plate.

Patent document number US2010/256788A1 describes an environmental condition monitor configured for simple upgrade from analog signal output to any of a plurality of digital communication protocols. A display board includes the analog signal acquisition and processing elements of the device and also includes a pre-positioned but initially inoperative digital communication output connector. A connector board associated with the display board includes a connector to which any one of a plurality of digital communication boards may be selectively connected, depending upon which of a plurality of digital communication protocols is desired. Selective connection of a digital communication board completes a circuit whereby an analog output signal is converted to the desired digital output format and is then communicated back to the now-activated digital communication output connector.

Patent document number US2014/321011A1 describes an electronic sub-assembly for an HVAC Controller which includes a touch screen display and a printed circuit board. The touch screen display includes a viewing side and a non-viewing side. A conductive trace is disposed on the viewing side of the touch screen display adjacent a perimeter of the touch screen display. The printed circuit board, which may include a grounding feature, is positioned adjacent the non-viewing side of the touch screen display. A connector is in electrical communication with the conductive trace and the grounding feature of the printed circuit board.

Patent document number US2008/013259A1 describes controller assemblies including a control unit releasably supported to a mounting plate. A controller assembly includes a mounting plate and a control unit that can be attached together via a number of latching mechanisms and corresponding mating recesses. Each latching mechanism can include a bendable latch and a latch shroud, which together are adapted to fit within a clearance area of the mating recess. The control unit can be removed from the mounting plate by rotating the control unit away from the mounting plate via a finger grip located along an edge of the assembly. The latching mechanisms can be configured to permit the staged removal of the control unit, reducing the force required to remove the control unit from the mounting plate.

Patent document number EP1113713A2 describes a wall mounted control device such as a thermostat which includes a front panel housing having a plurality of locating elements formed therein which allow the mounting of a display, a keyboard unit and a printed circuit board with respect to each other . The front panel housing includes a latch which engages an edge of the display following placement of the display into position within the front panel housing. The keyboard unit is positioned relative to the latched display. The printed circuit board is snapped into place beneath certain raised elements formed in the periphery of the front panel housing. The front panel housing with the thus assembled display, keyboard unit and printed circuit board therein is aligned and snap fitted to a rear or back housing of the wall mounted device.

Improvements in the hardware, user experience, and functionality of such HVAC controllers would be desirable.

### Summary

The present invention in its various aspects is as set out in the appended claims.

The present disclosure pertains generally to a wall mountable connector for securing a thermostat to a wall. The wall mountable connector may be configured to be secured relative to a vertical surface such as a wall, and to provide electrical connections between the wall mountable connector and a plurality of field wires that are operably coupled with HVAC equipment that the thermostat will be controlling. The wall mountable connector may also provide electrical connections between the wall mountable connector and the thermostat. In some cases, the wall mountable connector may include a door that is movable between an open position in which the electrical connections with the field wires are accessible and a closed position in which the electrical connections with the field wires are not accessible or visible.

In a particular example of the present disclosure, a wall mountable connector for securing a thermostat to a wall may include a housing having a front side and a back side, where the back side is configured to be mountable to a wall. The housing may define a field wire receiving cavity including a field wire aperture extending through the back side of the housing and into the field wire receiving cavity in order to receive one or more field wires. A connection block may be positioned alongside the field wire receiving cavity and may be configured to electrically connect to one or more field wires. A front side of the field wire receiving cavity may be open to allow a user to gain access and electrically connect one or more field wires in the field wire receiving cavity to the connection block. A door may be movable between a closed position and an open position, wherein in the closed position, the door is situated along the front side of the field wire receiving cavity and covers the field wire receiving cavity.

In some instances, the connection block may include a first connection block that is positioned along a side of the field wire receiving cavity and a second connection block that is positioned along the same side of the field wire receiving cavity and vertically spaced from the first connection block. In some cases, the first connection block includes a first grouping of pin terminals that are configured to accommodate a first grouping of pins extending backward from the thermostat, and a first grouping of wiring terminals with each of the first grouping of wiring terminals configured to electrically connect to a corresponding field wire in the field wire receiving cavity. In some cases, the second connection block includes a second grouping of pin terminals that are configured to accommodate a second grouping of pins extending backward from the thermostat, and a second grouping of wiring terminals with each of the second grouping of wiring terminals configured to electrically connect to a corresponding field wire in the field wire receiving cavity. In some cases, the door defines one or more apertures such that, when the door is in the closed position, the one or more apertures are aligned with and provide access to the first grouping of pin terminals and the second grouping of pin terminals.

The preceding summary is provided to facilitate an understanding of some of the features of the present disclosure and is not intended to be a full description. A full appreciation of the disclosure can be gained by taking the entire specification, claims, drawings, and abstract as a whole.

### Brief Description of the Figures

The disclosure may be more completely understood in consideration of the following description of various illustrative embodiments of the disclosure in connection with the accompanying drawings, in which:
Figure 1 is a perspective view of an illustrative thermostat assembly that may be used in an HVAC control system;
Figure 2 is an exploded perspective view of the illustrative thermostat assembly of Figure 1;
Figure 3 is a rear exploded perspective view of a thermostat and wall mountable connector forming the illustrative thermostat assembly of Figure 1;
Figure 4 is a rear perspective view of the thermostat and wall mountable connector of Figure 3, showing the wall mountable connector nestled within a recess in the back of the thermostat;
Figure 5 is an exploded perspective view of the wall mountable connector forming part of the illustrative thermostat assembly of Figure 1;
Figure 6 is a front view of the wall mountable connector forming part of the illustrative thermostat assembly of Figure 1, with the door shown in an open position;
Figure 7 is a rear view of the illustrative thermostat assembly of Figure 1, illustrating securement of a connection block with the wall mountable connector;
Figure 8 is an exploded view of a portion of the wall mountable connector, illustrating features within the wall mountable connector that support securement of the connection block of Figure 7;
Figure 9 is a bottom perspective view of the connection block of Figure 7;
Figure 10 is an upper perspective view of the connection block of Figure 7;
Figure 11 is a rear view of the thermostat forming part of the illustrative thermostat assembly of Figure 1, illustrating the pin apertures in the thermostat housing that help locate and align the printed circuit board of the thermostat within the thermostat housing;
Figure 12 is a schematic illustration of a printed circuit board of the thermostat including pins;
Figure 13 is a front view of the wall mountable connector, illustrating example label markings;
Figure 14A is a schematic front view of a first thermostat secured to a wall mountable connector;
Figure 14B is a schematic front view of a second thermostat secured to the wall mountable connector;
Figure 15 is a schematic block diagram of the wall mountable connector that may form part of the illustrative thermostat assembly of Figure 1, useful in combination with the first thermostat of Figure 14A and/or the second thermostat of Figure 14B;
Figure 16 is a front view of the wall mountable connector door, illustrating a possible location for an optional memory; and
Figure 17 is a side view of a thermostat secured to an optional table stand.

While the disclosure is amenable to various modifications and alternative forms, specifics thereof have been shown by way of example in the drawings and will be described in detail. It should be understood, however, that the intention is not to limit aspects of the disclosure to the particular illustrative embodiments described.

### Description

The following description should be read with reference to the drawings wherein like reference numerals indicate like elements. The drawings, which are not necessarily to scale, are not intended to limit the scope of the disclosure. In some of the figures, elements not believed necessary to an understanding of relationships among illustrated components may have been omitted for clarity.

All numbers are herein assumed to be modified by the term "about", unless the content clearly dictates otherwise. The recitation of numerical ranges by endpoints includes all numbers subsumed within that range (e.g., 1 to 5 includes 1, 1.5, 2, 2.75, 3, 3.80, 4, and 5).

As used in this specification and the appended claims, the singular forms "a", "an", and "the" include the plural referents unless the content clearly dictates otherwise. As used in this specification and the appended claims, the term "or" is generally employed in its sense including "and/or" unless the content clearly dictates otherwise.

It is noted that references in the specification to "an embodiment", "some embodiments", "other embodiments", etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is contemplated that the feature, structure, or characteristic may be applied to other embodiments whether or not explicitly described unless clearly stated to the contrary.

The present disclosure is directed generally at building automation system. Building automation systems are systems that control one or more operations of a building. Building automation systems can include HVAC systems, security systems, fire suppression systems, energy management systems and/or other systems. While HVAC systems with HVAC controllers are used as an example below, it should be recognized that the concepts disclosed herein can be applied to building automation systems more generally.

On one example, the present disclosure pertains to a thermostat assembly that combines a thermostat with a wall mountable connector. The wall mountable connector may, for example, be configured to be secured relative to a vertical surface such as a wall, and to provide electrical connections between the wall mountable connector and a plurality of field wires that are, for example, operably coupled with HVAC equipment that the thermostat will be controlling. The wall mountable connector may also provide electrical connections between the wall mountable connector and the thermostat. In some cases, the wall mountable connector may include a door that is movable between an open position in which the electrical connections with the field wires are accessible and a closed position in which the electrical connections with the field wires are not accessible or visible.

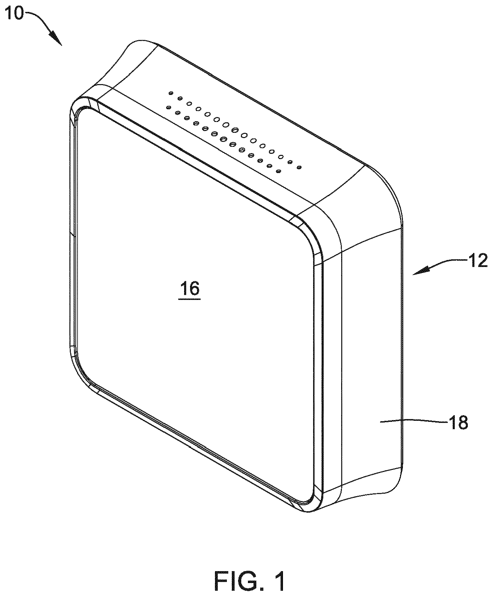

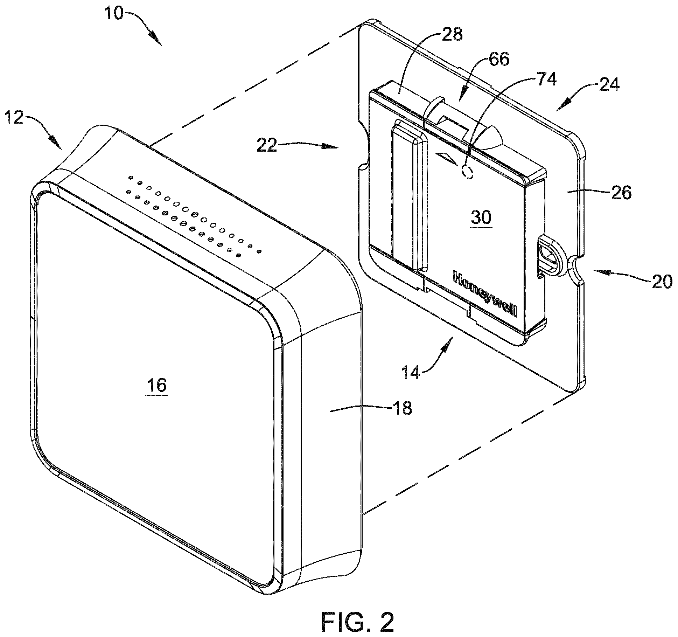

Figure 1 is a perspective view of an illustrative thermostat assembly 10, and Figure 2 is an exploded perspective view of the illustrative thermostat assembly 10 of Figure 1. In some instances, and with particular reference to Figure 2, the thermostat assembly 10 may include an HVAC Controller such as a thermostat 12, and a wall mountable connector 14. The wall mountable connector 14 may be configured to accommodate field wires that enter from a rear of the wall mountable connector 14. When so provided, the wall mountable connector 14 may provide an electrical connection between rearward extending terminals of the thermostat 12 and field wires of a corresponding HVAC system that extend from the wall. In the example shown, the wall mountable connector 14 may also provide a mechanical connection with the thermostat 12 and may thus be used to secure the thermostat 12 to the wall. In some instances, the wall mountable connector 14 itself may be secured to an electrical junction box or the like (not illustrated) disposed within the wall, but this is not required.

The thermostat 12 may include a user interface 16, which in some cases may be located at or near a front of the thermostat housing 18. While shown as a touch screen, without any distinct mechanical buttons, it will be appreciated that in some cases the user interface 16 may include one or more mechanical buttons that may be utilized to, for example, raise or lower a temperature set point, turn particular HVAC equipment on or off and/or perform other functions. If a touch screen is used, the user interface 16 may be a fixed segment touch screen display or perhaps a dot matrix touch screen display. The user interface 16 may display information in one color, such as black, against a single color background. In some cases, the user interface 16 may include a plurality of different colors.

In some instances, the wall mountable connector 14 may be considered as including a housing 20 having a front side 22 and a back side 24. The housing 20 may be considered as including a back portion 26 and a front portion 28. In some cases, the back portion 26 of the housing 20 may be configured to be mountable directly to a wall. In some cases, the back portion 26 of the housing 20 may be configured to be secured directly to a junction box disposed in the wall. In some cases, the front portion 28 may be configured to accommodate several field wires and to enable electrical connections to be made between the wall mountable connector 14 and the field wires. The field wires may be connected to HVAC equipment.

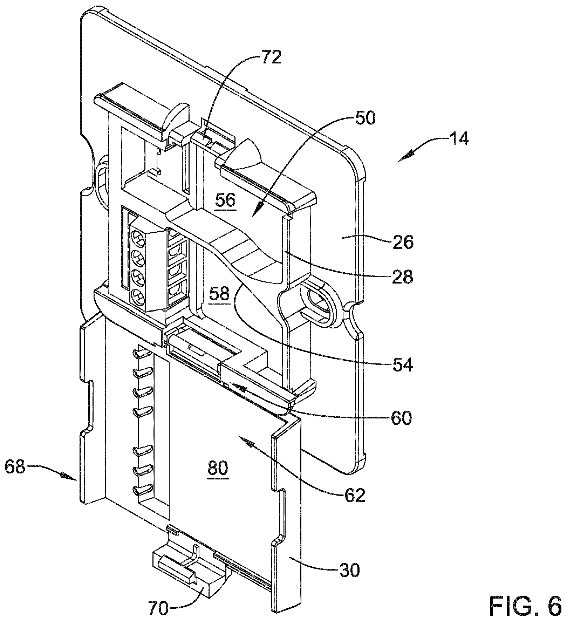

In some cases, a door 30 may be hingedly secured to the front portion 28. In some cases, the door 30 cooperates with the front portion 28 of the housing 20 to form an enclosure for the field wires entering the wall mountable connector 14 from the wall as well as the electrical connections between the field wires and the wall mountable connector 14. The door 30 may be movable between a closed position, as seen for example in Figure 2, and an open position as will be described with respect to Figure 6. When the door 30 is in the closed position, it will be appreciated that the door 30 may protect an individual from inadvertently coming into contact with the field wires within the housing 20. In some cases, the field wires may include at least some line voltage wires that may, for example, be at 220 volts or 240 volts. Moreover, when the door 30 is in the closed position, air flow entering from the wall, into the wall mountable connector 14, and to the back of the thermostat 12 may be substantially reduced or eliminated. This reduction in air flow from the wall may help improve the accuracy of any temperature sensors within the thermostat 12.

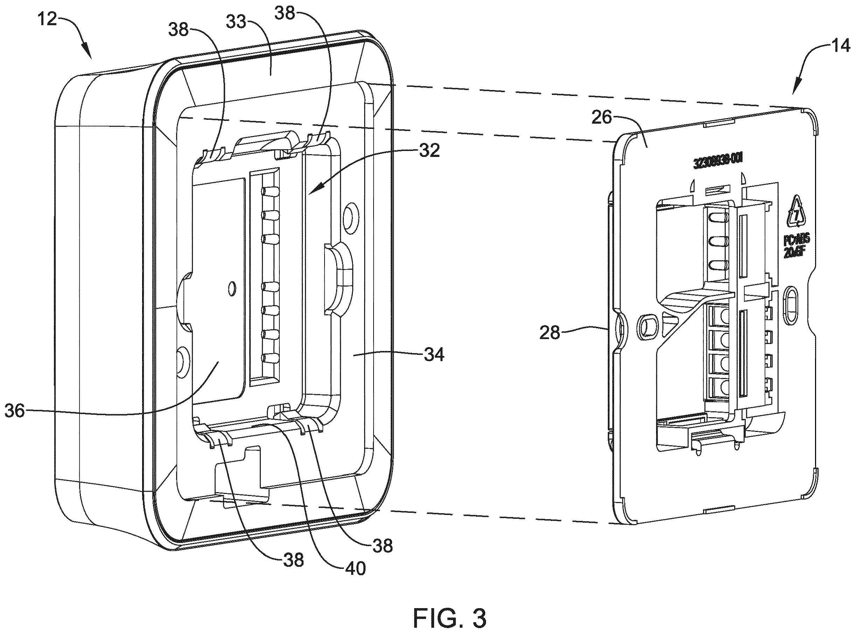

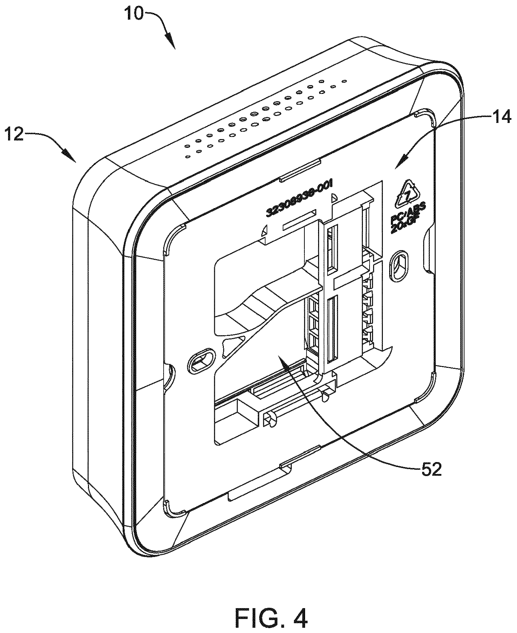

Figures 3 and 4 provide some details of the interaction between the thermostat 12 and the wall mountable connector 14. Figure 3 is an exploded perspective view showing the wall mountable connector 14 positioned behind the thermostat 12 (or showing the thermostat 12 in front of the wall mountable connector 14), while Figure 4 shows the wall mountable connector 14 nestled into a recess 32 in the back of the thermostat 12. In the example shown, the wall mountable connector 14 is sized and configured to fit within the recess 32 that is formed within a back side 34 of the thermostat 12. In some cases, the recess 32 may be considered as including an outer recess 34 of less depth that may be configured to accommodate at least part of the back portion 26 of the housing 20 (of the wall mountable connector 14), and an inner recess 36 or more depth that may be configured to accommodate at least part of the front portion 28 of the housing 20. In some cases, the recess 32, in combination with the front portion 28 of the housing 20 may be considered as providing a sort of lock and key interaction in which the thermostat 12 is not able to mechanically and electrically coupled to the wall mountable connector 14 if not properly orientated and aligned. In some cases, the front portion 28 of the housing 20 may be considered as forming or defining a male portion of the wall mountable connector 14.

Figure 4 shows the wall mountable connector 14 positioned and secured within the recess 32. In some cases, at least 90 percent of the volume of the wall mountable connector 14 fits within the recess 32 of the thermostat 12. In some cases, at least 95 percent of the volume of the wall mountable connector 14 fits within the recess 32. In some cases, at least 98 percent of the volume of the wall mountable connector 14 fits within the recess 32. In some cases, 100 percent of the volume of the wall mountable connector 14 fits within the recess 32. In some cases, when the wall mountable connector 14 is mounted to a wall, the back side 33 of the thermostat 12 may extend nearly to the wall, such as to less than 10 millimeters from the wall, to less than 5 millimeters from the wall, to less than 2 millimeters from the wall, or less.

In some cases, the thermostat 12 may include one or more latches 38 that are each disposed within a side wall 40 of the inner recess 36. As illustrated, there are a pair of latches 38 disposed along an upper side of the inner recess 36 and a pair of latches 38 that are disposed along a lower side of the inner recess 36. In some cases, there may be fewer than a total of four latches 38. In some cases, there may be more than four latches 38. In some cases, at least some of the latches 38 may be disposed along one or both sides of the inner recess 36 (e.g. left and/or right sides of the inner recess 36). Regardless of how many latches 38 are included, it will be appreciated that the latches 38 may be configured to help secure the thermostat 12 to the wall mountable connector 14. The thermostat 12 may also be mechanically secured to the wall mountable connector 14, in part, via interactions between a plurality of electrical pins extending from the thermostat 12 into the inner recess 36 and corresponding pin terminals of the wall mountable connector 14. In some cases, the latches 38 are configured to engage the front portion 28 of the wall mountable connector 14 when the wall mountable connector 14 is substantially inserted into the recess 32.

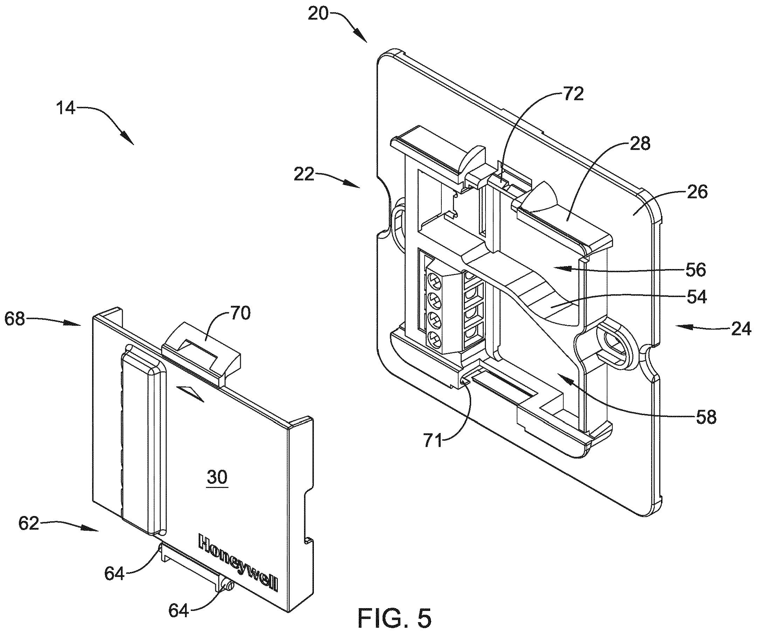

Figures 5 and 6 provide further details regarding the wall mountable connector 14. Figure 5 is an exploded perspective view of the wall mountable connector 14 in which the door 30, while in a closed position, has been pulled away to expose the interior of the wall mountable connector 14, while Figure 6 shows the door 30 in its open position in which the door 30 is hingedly secured to the wall mountable connector 14 and is hanging in a downward position. In the example shown, the front portion 28 of the housing 20 defines a field wire receiving cavity 50 that is open to the back, thus defining a field wire receiving aperture 52 through the back of the housing 20. In some cases, the housing 20 includes a partition 54 that divides the field wire receiving cavity 50 into an upper portion 56 and a lower portion 58. In some cases, the partition 54 may help separate field wires coupled with an upper connection block from field wires that are coupled with a lower connection block (as will be explained). In some cases, certain field wires may be low voltage wires (e.g. 24V or less) such as a remote sensor input or communication field wires, while other field wires may be line voltage (e.g. 220V or 240V).

In some cases, as illustrated, the door 30 may include a hinge 60, sometimes located at or near a lower end 62 of the door 30. In some cases, the hinge 60 may include a pin portion 64 that is molded with or otherwise formed with the door 30, and an aperture portion 71 that is molded with or otherwise formed into the front portion 28 of the housing 20. The pin portion 64 fits into the aperture portion 71 to provide a hinged connection between the wall mountable connector 14 and the door 30. In some instances, the door 30 may include a securement 66 (see Figure 2) that is disposed at or near an upper edge 68 of the door 30. In some cases, the securement 66 includes a clasp portion 70, molded with or otherwise formed into the upper edge 68 of the door 30 that interacts with a latch portion 72, molded with or otherwise formed into the front portion 28 of the housing 20. In some cases, the clasp portion 70 interacts with the latch portion 72 in such a way as to require use of a tool such as a screwdriver or other tool to pry the clasp portion 70 away from the latch portion 72 such that the door 30 can be moved from the closed position (see Figure 2) to the open position (see Figure 6). In some cases, this may help prevent inadvertent or accidental contact with the field wires by inexperienced users. In some cases, and as shown in phantom in Figure 2, a fastener 74, such as a screw or a bolt, may be used in combination with, or perhaps in place of, the securement 66 to help secure the door 30 in its closed position. In some cases, the screw or bolt may be shaped to require a specialized tool to turn the screw or bolt, such as a screw driver that has a specialized driver pattern (e.g. star, triangular or other specialized shape) to help prevent access to the field wires by inexperienced homeowners.

In the example shown, the door 30 may include an inner surface 80. In some cases, the inner surface 80 may include printed information. Illustrative but nonlimiting examples of such printed information include text instructing the user to check a website for thermostat compatibility information, text providing the user with instructions such as how to strip the insulation off of the field wires and/or a scaled diagram showing how much insulation to strip off. The scale of the diagram can be 1:1, which may allow the user to use the diagram to measure out how much insulation to strip off. In some cases, the printed information may include, for example, a wiring diagram instructing an individual where each field wire should be connected. In some cases, the inner surface 80 may provide an installer a location to place a sticker providing their contact information.

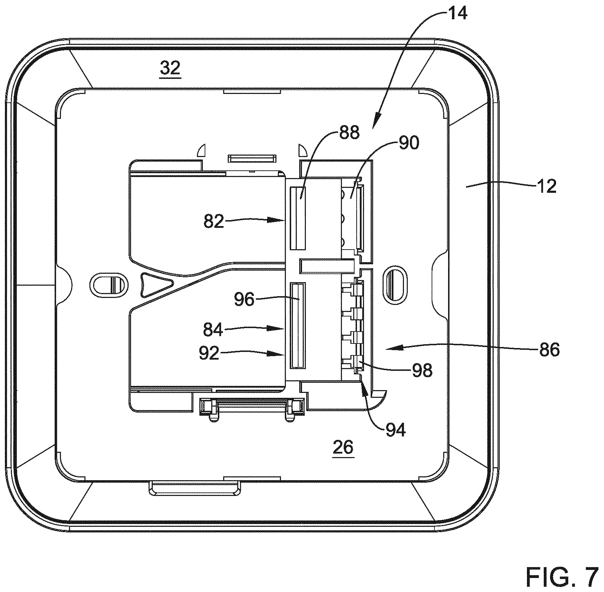

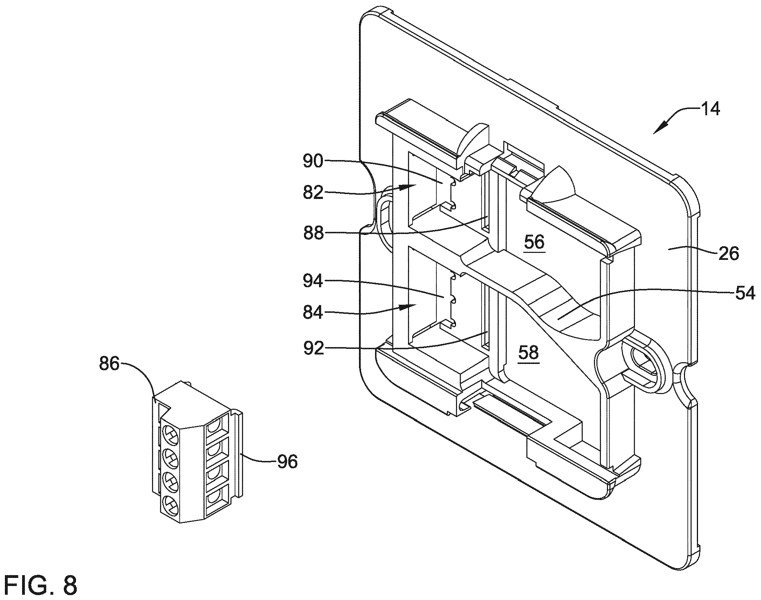

Figures 7 through 10 provide further details regarding the connection block(s) that forms part of the illustrative wall mountable connector 14 and that facilitates the electrical connections between field wires and the wall mountable connector 14 and thus ultimately between the field wires and the thermostat 12. Figure 7 is a back view of the wall mountable connector 14 disposed within the thermostat 12, and Figure 8 is a front view of the wall mountable connector 14. It will be appreciated that the front portion 28 of the housing 20 defines an upper connection block space 82 and a lower connection block space 84. In some cases, there may be an upper connection block (not illustrated) secured within the upper connection block space 82 and a lower connection block secured within the lower connection block space 84. In some cases, there is only a single connection block secured within the lower connection block space 84. Depending on the particulars of the HVAC equipment, an upper connection block may or may not be used.

As illustrated in Figure 7, and viewing from the back side, a connection block 86 is secured in position within the lower connection block space 84. In the example shown, the upper connection block space 82 includes a first mounting aperture 88 configured to engage a corresponding flange on a connection block, and a second mounting aperture 90 configured to engage one or more corresponding mounting tabs on the connection block. Likewise, the lower connection block 84 may include a first mounting aperture 92 configured to engage a corresponding flange such as a flange 96 on connection block 86, and a second mounting aperture 94 configured to engage one or more corresponding mounting tabs such as mounting tabs 98 on the connection block 86.

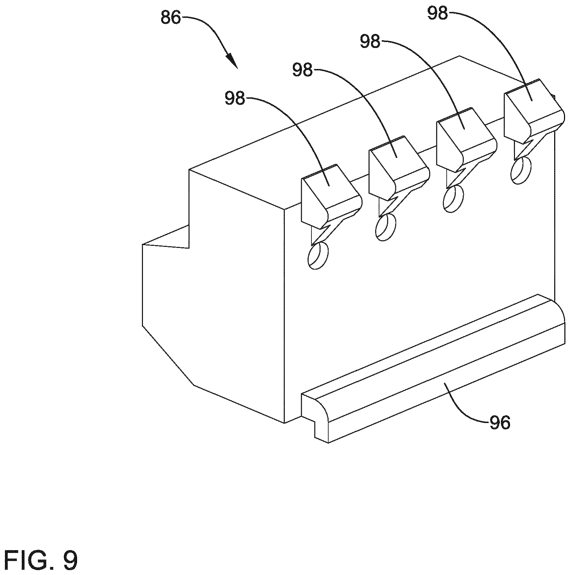

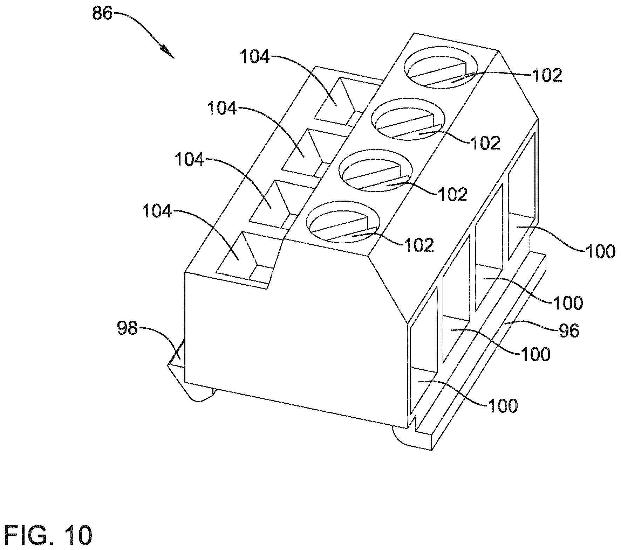

The illustrative connection block 86 is better seen in Figures 9 and 10, clearly showing the flange 96 and the mounting tabs 98. While the connection block 86 as illustrated is configured to fit into the lower connection block space 84, it will be appreciated that a similar connection block may be made to fit into the smaller upper connection block space 82. In some instances, the upper connection block space 82 may be configured to accommodate a connection block providing spaces for up to three field wires while the lower connection block space 84 may be configured to accommodate a connection block, such as the connection block 86, providing spaces for up to four field wires. For example, the connection block 86 includes a total of four field wire apertures 100 that are each configured to accommodate the end of a field wire that has had a small length of insulation stripped off. A total of four mounting screws 102 (see Figure 10), one corresponding to each of the four field wire apertures 100, may be loosened to permit insertion of a field wire into the corresponding field wire aperture 100 and then subsequently tightened down to secure the field wire in place. A total of four pin terminals 104, each corresponding to a particular one of the field wire apertures 100, are configured to accommodate pins extending out the back of the inner recess 36. While not illustrated, it will be appreciated that the connection block 86 internally provides an electrical connection between each field wire aperture 100 and the corresponding pin terminal 104.

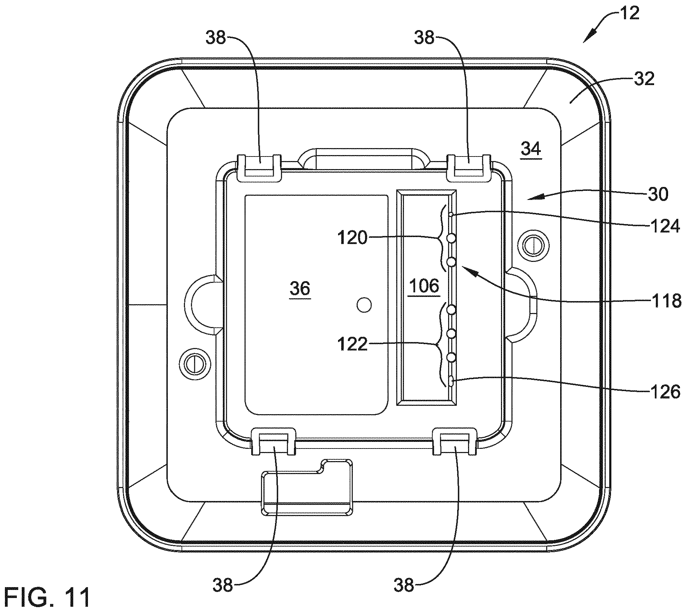

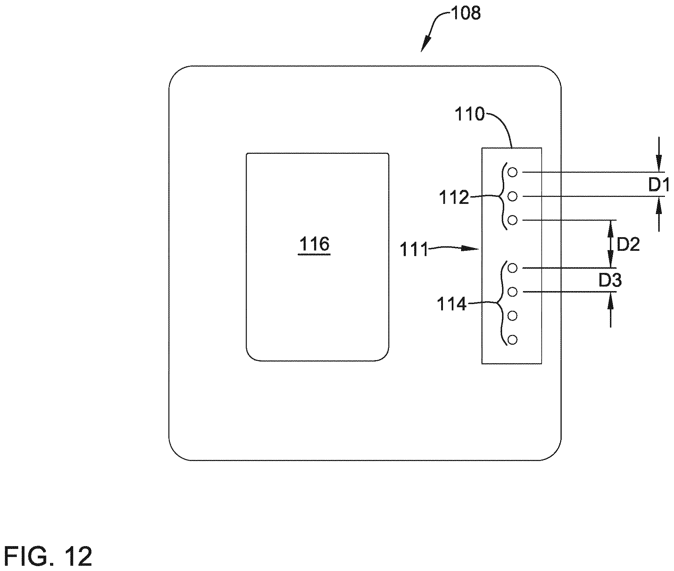

Figures 11 and 12 illustrate efficiently locating a printed circuit board within a thermostat 12 housing via alignment of the pins extending from the printed circuit board and through apertures within a rear surface of the thermostat 12. Figure 11 shows the back of the thermostat 12, while Figure 12 is a schematic illustration of a printed circuit board 108 that may be disposed within the thermostat 12. The printed circuit board 108 includes a pin header 110 that is secured to the printed circuit board 108 and includes a plurality of pins 111. In some cases, the plurality of pins 111 may be considered as forming a first grouping 112 of pins and a second grouping 114 of pins. As can be seen, the inner recess 36 of the thermostat 12 includes a further recessed portion 106 including a plurality of pin apertures 118 through the thermostat housing. In some cases, the plurality of pin apertures 118 may be considered as including a first grouping 120 of pin apertures and a second grouping 122 of pin apertures. The first grouping 120 of pin apertures may be alignable with the first grouping 112 of pins while the second grouping 122 of pin apertures may be alignable with the second grouping 114 of pins, for example. In some cases, the printed circuit board 108 includes a controller 116 for controlling the operation of the thermostat 12.

In some cases, the first grouping 120 of pin apertures and/or the second grouping 122 of pin apertures may include a lateral alignment aperture that helps to provide a lateral alignment of the printed circuit board 108 within the thermostat housing. In some cases, the first grouping 120 of pin apertures and/or the second grouping 122 of pin apertures may include a rotational alignment aperture that helps to provide a rotational alignment of the printed circuit board 108 with the thermostat housing. In some instances, the lateral alignment aperture and the rotational alignment aperture may both be disposed within the first grouping 120 of pin apertures. In some instances, the lateral alignment aperture and the rotational alignment aperture may both be disposed within the second grouping 122 of pin apertures. In some cases, as illustrated, a lateral alignment aperture 124 may be disposed within the first grouping 120 of pin apertures while a rotational alignment aperture 126 may be disposed within the second grouping 122 of pin apertures.

In some cases, the lateral alignment aperture 124 may have a smaller dimension (e.g. diameter) than other of the apertures. In some instances, the rotational alignment aperture 126 may have a narrowed dimension in a first dimension (e.g. left-right) and a wider dimension in an orthogonal direction (e.g. up-down). In some cases, the rotational alignment aperture 126 may be oblong or elliptical in shape. The rotational alignment aperture 126 may be configured to provide a tighter fit in the first dimension with one of the pins in order to provide a rotational alignment of the printed circuit board 108 relative to the thermostat housing.

In some cases, the wider dimension in the orthogonal direction may reduce stress applied to the corresponding terminal pin when assembling the printed circuit board 108 with the thermostat 12 and/or during subsequent use. In some cases, the remainder of pin apertures 118, apart from the lateral alignment aperture 124 and the rotational alignment aperture 126, may be dimensioned looser, relative to a diameter of the terminal pins, in order to reduce stress during assembly and/or use. Thus, in some cases, the remaining pin apertures 118 may have diameters that exceed the diameters of the terminal pins.

In some cases, each of the pins within the first grouping of pins 112 may have an inter-pin spacing indicated by D₁ while each of the pins within the second grouping of pins 114 may have an inter-pin spacing indicated by D₃. While in many cases the dimension D₁ will be equal to D₃, it will be appreciated that in some instances, the dimension D₁ may not be equal to D₃. There may be a spacing indicated by a dimension D₂ between a lowermost of the first grouping of pins 112 and an uppermost of the second grouping of pins 114. While in some cases the dimension D₂ may be equal to D₁ and/or to D₃, in many cases, as illustrated, the dimension D₂ is greater than the dimension D₁ or the dimension D₂. In some cases, the dimension D₁ is in the range of about 4 millimeters to about 10 millimeters. In some cases, the dimension D₃ is in the range of about 4 millimeters to about 10 millimeters.

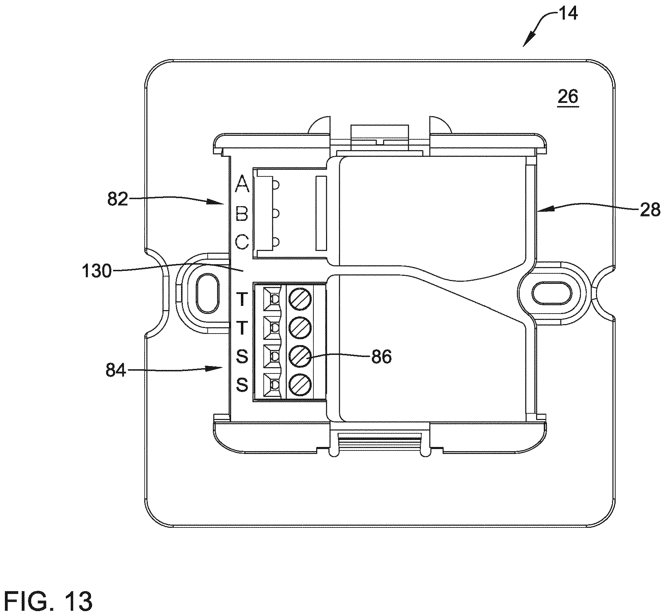

In some cases, the wall mountable connector 14 may include labels or other markings to indicate which field wire should be connected to each field wire aperture 100 (Figure 10). Figure 13 is a front view of the wall mountable connector 14, showing the upper connection block space 82 and the lower connection block space 84. As illustrated, the connection block 86 is secured in place within the lower connection block space 84. It will be appreciated that a wall 130, partially defining the upper connection block space 82 and the lower connection block space 84, provides a useful space for providing labels. In the illustrated example, the lower connection block space 84 includes markings, top to bottom, of T, T, S and S. In this example, the two terminals marked T and T are for thermostat power connections and are not polarized. The two terminals marked S and S indicate connections for a remote sensor. In some cases, the lower connection block space 84 may instead include markings of OT, OT, S and S. In this example, the two terminals marked OT and OT indicate an Open Therm connection, which is a communications link to a boiler or the like. As previously noted, in some cases the upper connection block space 82 may accommodate a connection block as well (not shown). In some cases, if there is a connection block disposed within the upper connection block space 82, there may be corresponding labeling. It can be seen that the upper connection block space 82 may be labeled A, B, C (as shown in phantom). The terminal labeled A may corresponds to a common terminal for a relay, the terminal labeled B may corresponds to a normally open (NO) contact and the terminal labeled C may correspond to a normally closed (NC) contact.

It will be appreciated that thermostats having other configurations may be configured to work with the wall mountable connector 14. In some cases, a variety of different thermostats may be used with the wall mountable connector 14. As a result, a first thermostat may be removed from the wall mountable connector 14 and may be disposed of. A second thermostat, which may have the same shape as the first thermostat, or which may have a different shape and/or functionality, may then be secured to the same wall mountable connector 14. In some cases, the wall mountable connector 14 may be considered as a universal wall mountable connector, enabling installation of a variety of different compatible thermostats without having to disconnect the field wires from the first thermostat and then connect the field wires to the second thermostat. Rather, one may simply pull the first thermostat off the wall mountable connector 14 and subsequently push the second thermostat onto the wall mountable connector 14 in order to install the second thermostat, without requiring any tools or wiring knowledge. Further, a thermostat may be easily and temporarily removed for painting, for example, and subsequently snapped back into place on the wall mountable connector 14 afterwards.

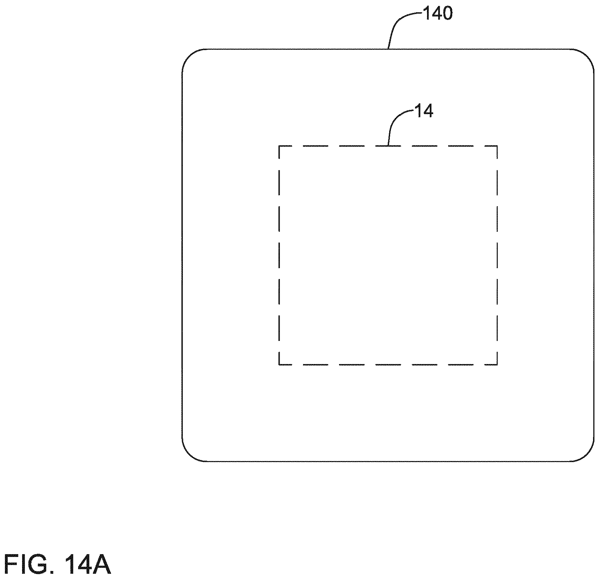

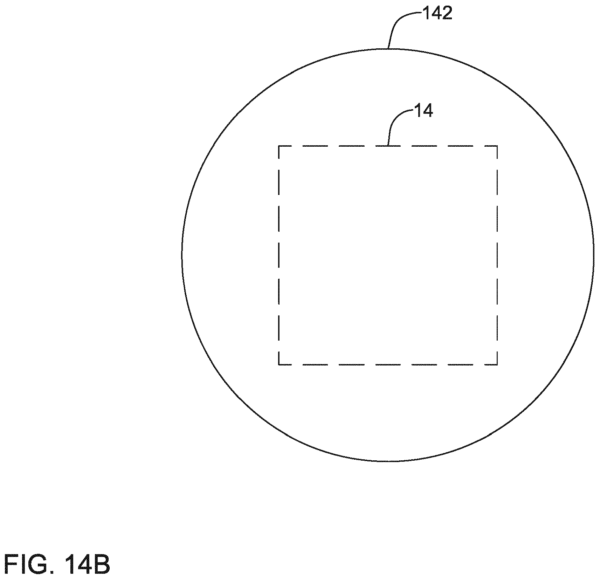

As noted, in some cases the wall mountable connector 14 may be considered as being a universal wall mountable connector, usable with any number of different compatible thermostat configurations. Figure 14A illustrates a first thermostat 140 that is secured in position on the wall mountable connector 14. Since this is a front view of the thermostat 140, it will be appreciated that the wall mountable connector 14 is shown in phantom. Figure 14B illustrates a second thermostat 142 that is secured in position on the wall mountable connector 14. In some cases, the first thermostat 140 may represent an initially or previously installed thermostat, and the second thermostat 142 may represent a replacement thermostat. In some instances, the wall mountable connector 14 is configured to enable a user to remove the first thermostat 140 from the wall mountable connector 14 and to install a new, different, thermostat such as the second thermostat 142, without having to disconnect and connect any field wires that are operably coupled with the wall mountable connector 14. For example, the second thermostat 142 may have enhanced features that are not present in the first thermostat 140.

In some cases, the first thermostat 140 may have stored information such as stored configuration and/or programming information that may be useful to the second thermostat 142. For example, the stored information may include thermostat configuration data, such as but not limited to, thermostat scheduling data such as a programmable schedule, information about the HVAC system that is to be controlled (e.g. furnace type, number of stages, etc.), thermostat settings (e.g. WiFi password, low temperature limit), contractor information (e.g. contractor name, address, contractor information, and logo), and/or other information. In some cases, the stored information may include login information for a local wireless source and/or a remote server for which the thermostat 12 may communicate during operation.

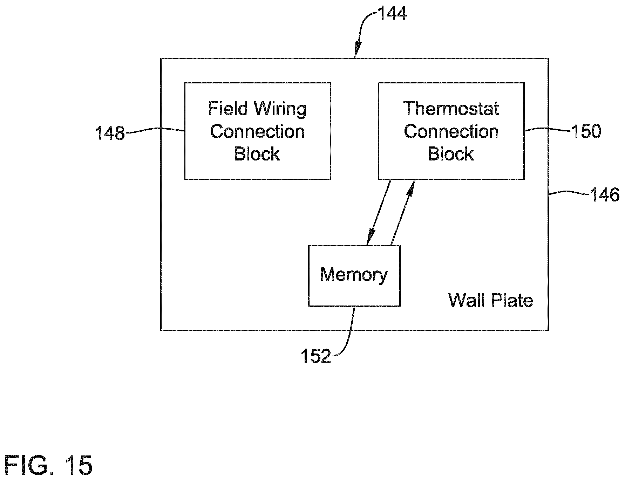

Figure 15 is a schematic block diagram of a wall mountable connector 144 that may be considered as representing the wall mountable connector 14 and that may be used in combination with the first thermostat 140 and/or the second thermostat 142. The illustrative wall mountable connector 144 includes a housing 146 that may be configured to be mounted to a wall and is configured to provide a standardized mechanical connection between the wall mountable connector 144 and each of the first thermostat 140, the second thermostat 142 (and in some cases other thermostats that are in a line of compatible thermostats). The wall mountable connector 144 may include a field wiring connection block 148 that is configured to provide an electrical connection between the wall mountable connector 144 and a plurality of field wires that are coupled with the HVAC system. In some cases, the field wiring connection block 148 may be replaced by a wireless connection block that is configured to provide wireless communication between the wall mountable connector 144 and an HVAC system that is to be controlled via the wall mountable connector 144. A thermostat connection block 150 may provide a standardized electrical connection between the wall mountable connector 144 and the thermostats 140, 142. The wall mountable connector 144 may be electrically coupled to the thermostat 140, 142 via the thermostat connection block 150, and the wall mountable connector 144 may be communicatively coupled to the HVAC system via the field wiring connection block 148 and/or the wireless connection block (not shown). When so provided, there may be a standardized mechanical and electrical connection to the wall mountable connector 144 such that the first thermostat 140 may be removed and replaced with the second thermostat 142.

In some cases, the wall mountable connector 144 may further include a memory 152 (e.g. non-volatile memory) that is configured to store data and/or other information that was communicated to the memory 152 by a first thermostat from a line of compatible thermostats (e.g. from first thermostat 140). In some cases, the data and/or other information may be communicated from the first thermostat automatically or on-command. In some cases, the memory 152 may be configured to communicate the stored data and/or information to a subsequently installed second thermostat from the line of compatible thermostat (e.g. to the second thermostat 142). In some cases, the memory 152 may be configured to communicate with each thermostat in the line of compatible thermostats. In some instances, for example, the memory 152 may be configured to, automatically or on-command, communicate the stored data and/or information to the subsequently installed second thermostat to at least partially configure the subsequently installed second thermostat using settings from the first thermostat. This information may include thermostat configuration data, such as but not limited to, thermostat scheduling data such as a programmable schedule, information about the HVAC system that is to be controlled (e.g. furnace type, number of stages, etc.), thermostat settings (e.g. WiFi password, low temperature limit), contractor information (e.g. contractor name, address, contractor information, and logo), and/or other information. In some cases, the stored information may include login information for a local wireless source and/or a remote server.

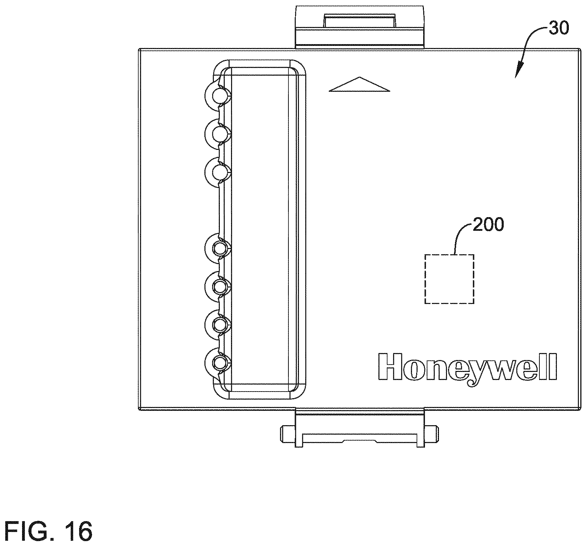

In some cases, the wall mountable connector 14 may, as referenced with respect to Figure 15 and wall mountable connector 144, include a memory 200 that may be configured to store data, settings and/or other information that is communicated by an initially installed thermostat, such as but not limited to, the first thermostat 140 (Figure 14A), and to communicate the stored data, settings and/or other information to a subsequently installed second thermostat such as, but not limited to, the second thermostat 142 (Figure 14B). In some cases, the memory 200 may be disposed somewhere within the field wire receiving cavity 50. In some cases, the memory 200 may be secured to a back side of the door 30, as shown in phantom in Figure 16.

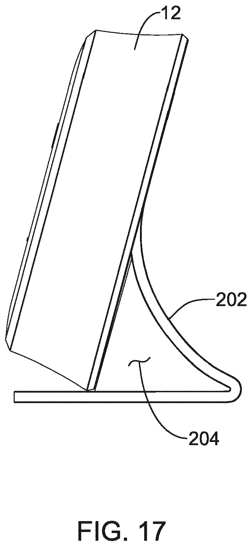

In some cases, the thermostat 12 may not be coupled to a wall mountable connector such as the wall mountable connector 14. In some cases, as shown for example in Figure 17, the thermostat 12 may instead be secured to a table stand 202. Like the wall mountable connector 14 discussed above, the table stand 202 may include pin terminals configured to make electrical contact with corresponding pins extending from the rear of the thermostat 12. In some cases, an electrical connector (not illustrated) may extend from the table stand 202. In some instances, the table stand 202, or perhaps the thermostat 12, may include wireless communications capability, and thus may communicate wirelessly with a remote device that is itself electrically coupled with field wires and thus electrically coupled with the HVAC system. In some cases, the table stand 202, or perhaps the thermostat 12, may include wireless communications capability, and may communicate wirelessly with the HVAC system.

In some cases, the table stand 202 may include a power supply in the base 204. The power supply may be connected to a power cord that can be plugged into a power outlet of the building. The power supply may deliver appropriate power to the thermostat and/or components of the table stand 202. In some instances, the power supply may be removed from the base and replaced should the power supply fail.

### Additional Examples

### Printed Circuit Board Alignment Examples

Example 1. A thermostat configured to couple to a wall mountable connector, the thermostat comprising:
   a housing including a rear facing surface;
   a printed circuit board disposed within the housing;
   a row of terminal pins disposed in a pin header and secured to the printed circuit board;
   a recess formed within the rear facing surface, the recess configured to fit over at least part of the wall mountable connector, the recess including a rear facing recess surface;
   a row of apertures formed in the rear facing recess surface configured to accommodate the row of terminal pins;
   the row of apertures including a lateral alignment aperture that is configured to provide a tighter fit with one of the row of terminal pins in order to provide a lateral alignment of the printed circuit board relative to the rear facing recess surface of the housing; and
   the row of apertures further including a rotational alignment aperture having a narrowed dimension in a first direction and a wider dimension in an orthogonal second direction, the rotational alignment aperture configured to provide a tighter fit with another of the row of terminal pins in the first direction in order to provide a rotational alignment of the printed circuit board relative to the rear facing recess surface of the housing.
Example 2. The thermostat of example 1, wherein the rotational alignment aperture has a narrower dimension in a first direction that is orthogonal to the row of apertures.
Example 3. The thermostat of any one of examples 1 or 2, wherein a remainder of the row of apertures, apart from the lateral alignment aperture and the rotational alignment aperture, are dimensioned looser to reduce stress applied to the row of terminal pins during assembly and/or use.
Example 4. The thermostat of any one of examples 1 to 3, wherein the remainder of the row of apertures have a diameter that is larger than that of the terminal pins within the row of terminal pins.
Example 5. The thermostat of any one of examples 1 to 4, wherein the rotational alignment aperture is spaced apart from the lateral alignment aperture by one or more intervening apertures within the row of apertures.
Example 6. A thermostat configured to couple to a wall mountable connector, the thermostat comprising:
   a housing including a rear facing surface;
   a printed circuit board disposed within the housing;
   a first grouping of terminal pins disposed in a first pin header and secured to the printed circuit board;
   a second grouping of terminal pins disposed in a second pin header and secured to the printed circuit board;
   a recess formed within the rear facing surface, the recess configured to fit over at least part of the wall mountable connector, the recess including a rear facing recess surface;
   a first grouping of apertures formed in the rear facing recess surface configured to accommodate the first grouping of terminal pins;
   a second grouping of apertures formed in the rear facing recess surface configured to accommodate the second grouping of terminal pins;
   one of the first grouping of apertures and the second grouping of apertures including a lateral alignment aperture that is configured to provide a tighter fit with one of the terminal pins in order to provide a lateral alignment of the printed circuit board relative to the rear facing recess surface of the housing; and
   one of the first grouping of apertures and the second grouping of apertures further including a rotational alignment aperture having a narrowed dimension in a first direction and a wider dimension in an orthogonal second direction, the rotational alignment aperture configured to provide a tighter fit with another of the terminal pins in the first direction in order to provide a rotational alignment of the printed circuit board relative to the rear facing recess surface of the housing.
Example 7. The thermostat of example 6, wherein a remainder of the first grouping of apertures and the second grouping of apertures, apart from the lateral alignment aperture and the rotational alignment aperture, are dimensioned looser to reduce stress applied to the terminal pins during assembly and/or use.

### Thermostat/Wall mountable connector Alignment and Connection Examples

Example 1. A wall mountable connector for securing a thermostat to a wall, the wall mountable connector comprising:
   a housing having a front side and a back side, the back side is configured to be mountable to a wall;
   the housing defining a male portion that extends away from the back side and to the front side of the housing, the male portion is configured to extend into and be received by a recess in a back side of a thermostat;
   the housing defining a field wire aperture through the back side of the housing to accommodate one or more field wires; and
   a first grouping of pin terminals configured to accommodate a first grouping of pins extending from the back side of a thermostat, the first grouping of pin terminals being positioned on the male portion of the housing such that the first grouping of pin terminals are only aligned to accept the first grouping of pins extending from the back side of the thermostat when the thermostat is properly oriented and aligned relative to the wall mountable connector.
Example 2. The wall mountable connector of example 1, wherein the male portion of the housing is shaped to be keyed to the recess in the back side of the thermostat so as to only allow the male portion of the housing to be fully received by the recess in the back side of the thermostat when the thermostat is properly oriented and aligned relative to the wall mountable connector.
Example 3. The wall mountable connector of any one of examples 1 or 2, further comprising:
   a second grouping of pin terminals configured to accommodate a second grouping of pins extending from the back side of the thermostat, the second grouping of pin terminals being positioned on the male portion of the housing such that the second grouping of pin terminals are only aligned to accept the second grouping of pins extending from the back side of the thermostat when the thermostat is properly oriented and aligned relative to the wall mountable connector.
Example 4. The wall mountable connector of example 3, wherein the first grouping of pin terminals is vertically aligned with and positioned vertically above the second grouping of pin terminals.
Example 5. The wall mountable connector of example 4, wherein a spacing between a bottom pin terminal of the first grouping of pin terminals and a top pin terminal of the second grouping of pin terminals is greater than a spacing between adjacent pin terminals within the first grouping of pin terminals or within the second grouping of pin terminals.
Example 6. The wall mountable connector of example 5, wherein the spacing between adjacent pin terminals within the first grouping of pin terminals is equal to the spacing between adjacent pin terminals within the second grouping of pin terminals.
Example 7. A thermostat that is configured to be mounted to a wall mountable connector, the wall mountable connector providing a mechanical connection to a wall as well as electrical connections between the thermostat and field wires exiting the wall, the thermostat comprising:
   a housing having a front side and a back side;
   a recess formed within the back side, the recess configured to accommodate a male portion of a wall mountable connector, the recess defining a recess back surface;
   a user interface accessible from the front side of the housing;
   a printed circuit board disposed within the housing and operably coupled to the user interface;
   a first grouping of pins secured to the printed circuit board and extending through the recess back surface, the first grouping of pins configured to engage a corresponding first grouping of pin terminals of the wall mountable connector; and
   the first grouping of pin terminals being positioned in the recess such that the first grouping of pins only engage the first grouping of pin terminals of the wall mountable connector when the thermostat is properly oriented and aligned relative to the wall mountable connector.
Example 8. The thermostat of example 7, further comprising:
   a second grouping of pins secured to the printed circuit board and extending through the recess back surface, the second grouping of pins configured to engage a corresponding second grouping of pin terminals of the wall mountable connector; and
   the second grouping of pin terminals of the wall mountable connector being positioned in the recess such that the second grouping of pins only engage the second grouping of pin terminals of the wall mountable connector when the thermostat is properly oriented and aligned relative to the wall mountable connector.
Example 9. The thermostat of any one of examples 7 or 8, wherein the first grouping of pin terminals have an inter-pin terminal spacing of between 4 and 10 millimeters.
Example 10. The thermostat of any one of examples 7 or 9, wherein the second grouping of pin terminals have an inter-pin terminal spacing of between 4 and 10 millimeters.
Example 11. The thermostat of any one of examples 7 to 10, wherein the recess in the back side of the thermostat is shaped to be keyed to the male portion of the wall mountable connector so as to only allow the male portion of the wall mountable connector to be fully received by the recess in the back side of the thermostat when the thermostat is properly oriented and aligned relative to the wall mountable connector.
Example 12. The thermostat of any one of examples 7 to 11, further comprising a controller to operate the thermostat.
Example 13. A thermostat that is configured to be mounted to a wall mountable connector, the wall mountable connector providing a mechanical connection to a wall as well as electrical connections between the thermostat and field wires exiting the wall, the thermostat comprising:
   a housing having a front side and a back side;
   a wall mountable connector recess formed within the back side, the wall mountable connector recess configured to accommodate a male portion of a wall mountable connector, the wall mountable connector recess defining a recess back surface and recess side surfaces; and
   a plurality of latch features formed within the wall mountable connector recess, the plurality of latch features configured to engage the male portion of the wall mountable connector when the wall mountable connector is fully engaged in the wall mountable connector recess, the plurality of latch features providing a mechanical connection between the thermostat and the wall mountable connector.
Example 14. The thermostat of example 13, wherein at least some of the plurality of latch features are positioned in one or more of the recess side surfaces.
Example 15. The thermostat of any one of examples 13 or 14, wherein the wall mountable connector further comprises:
   a door covering at least a portion of the wall mountable connector, wherein the door includes a door securement feature, and
   wherein the thermostat comprises a corresponding cutout feature in one or more of the recess side surfaces to accommodate the door securement feature.
Example 16. The thermostat of any one of examples 13 to 15, wherein the wall mountable connector recess has an overall width that is less than about 60 millimeters.
Example 17. The thermostat of any one of examples 13 to 16, wherein the wall mountable connector recess has an overall height that is less than about 70 millimeters.

## Claims

1. A wall mountable connector (14) for securing a thermostat to a wall, the wall mountable connector (14) comprising:
a housing (20) having a front side (22) and a back side (24), the back side (24) is configured to be mountable to a wall;
the housing (20) defining a field wire receiving cavity (50) including a field wire aperture (52) extending through the back side (24) of the housing (20) and into the field wire receiving cavity (50) in order to receive one or more field wires;
a connection block positioned alongside the field wire receiving cavity (50), the connection block configured to electrically connect to one or more field wires;
a front side of the field wire receiving cavity is open to allow a user to gain access and electrically connect one or more field wires in the field wire receiving cavity to the connection block; **characterized by**
a door (30) movable between a closed position and an open position, wherein in the closed position, the door (30) is situated along the front side of the field wire receiving cavity (50) and covers the field wire receiving cavity.

2. The wall mountable connector of claim 1, wherein the connection block comprises:
a grouping of pin terminals (104) configured to accommodate a grouping of pins extending backward from the thermostat; and
a grouping of wiring terminals, with each of the wiring terminals is configured to electrically connect to a corresponding field wire.

3. The wall mountable connector of any one of claims 1 or 2, wherein the connection block is configured to snap into the housing.

4. The wall mountable connector of claim 3, wherein the connection block comprises a securement flange (96) along one side of the connection block and one or more securement tabs (98) along an opposing second side of the connection block, and the housing is configured to accommodate the securement flange and the one or more securement tabs in order to secure the connection block to the housing.

5. The wall mountable connector of any one of claims 1 to 4, wherein, when the door (30) is in the open position, the door is moved away from the front side of the field wire receiving cavity to provide user access to the field wire receiving cavity and the connection block.

6. The wall mountable connector of any one of claims 1 to 5, wherein the door (30) is secured to the housing via a hinge (60) disposed at or near a lower end of the door.

7. The wall mountable connector of any one of claims 1 to 6, wherein the door (30) further comprises a securement (66) located at or near an upper end of the door, the securement configured to releasably secure the door in the closed position, and is releasable from the closed position via an interaction with a tool.

8. The wall mountable connector of claim 2, wherein the grouping of wiring terminals includes a first thermostat power wiring terminal, a second thermostat power wiring terminal, and one or more sensor wiring terminals.

9. The wall mountable connector of claim 2, wherein the grouping of wiring terminals includes at least one communication wiring terminal and at least one sensor wiring terminal.

10. The wall mountable connector of claim 1, wherein the connection block comprises:
a first connection block positioned along a side of the field wire receiving cavity, the first connection block comprising:
a first grouping of pin terminals configured to accommodate a first grouping of pins extending backward from the thermostat;
a first grouping of wiring terminals, with each of the first grouping of wiring terminals configured to electrically connect to a corresponding field wire;
a second connection block positioned along the same side of the field wire receiving cavity and vertically spaced from the first connection block, the second connection block comprising:
a second grouping of pin terminals configured to accommodate a second grouping of pins extending backward from the thermostat;
a second grouping of wiring terminals, with each of the second grouping of wiring terminals configured to electrically connect to a corresponding field wire; and
wherein when the door is in the closed position, the door covers the first grouping of wiring terminals and the second grouping of wiring terminals but does not cover the first grouping of pin terminals or the second grouping of pin terminals.

11. The wall mountable connector of claim 10, wherein the door (30) defines one or more apertures such that, when the door is in the closed position, the one or more apertures are aligned with and provide access to the first grouping of pin terminals and the second grouping of pin terminals.

12. The wall mountable connector of any one of claims 10 or 11, wherein the first connection block is vertically above the second connection block, and the first grouping of wiring terminals includes a relay common wiring terminal, and one or more of a normally open NO wiring terminal and a normally closed NC wiring terminal.

13. The wall mountable connector of any one of claims 10 to 12, wherein the second grouping of wiring terminals includes a first thermostat power wiring terminal, a second thermostat power wiring terminal, and one or more sensor wiring terminals.

14. The wall mountable connector of any one of claims 10 to 12, wherein the second grouping of wiring terminals includes one or more communication wiring terminal and one or more sensor wiring terminals.

15. The wall mountable connector of any one of claims 10 to 14, wherein the housing further comprises a dividing wall that divides the field wire receiving cavity into an upper portion to access the first connection block and a lower portion to access the second connection block.

## Patentansprüche

1. Wandmontageverbinder (14) zum Befestigen eines Thermostats an einer Wand, wobei der Wandmontageverbinder (14) Folgendes umfasst:
ein Gehäuse (20) mit einer Vorderseite (22) und einer Rückseite (24), die Rückseite (24) ist so konfiguriert, dass sie sich an einer Wand montieren lässt;
wobei das Gehäuse (20) einen Feldkabelaufnahmehohlraum (50), der eine durch die Rückseite (24) des Gehäuses (20) in den Feldkabelaufnahmehohlraum (50) hinein verlaufende Feldkabelöffnung (52) enthält, definiert, um ein oder mehrere Feldkabel aufzunehmen;
einen entlang einer Seite des Feldkabelaufnahmehohlraums (50) positionierten Verbindungsblock, wobei der Verbindungsblock konfiguriert ist, um elektrisch mit einem oder mehreren Feldkabeln verbunden zu werden;
eine Vorderseite des Feldkabelaufnahmehohlraums ist offen, um zu ermöglichen, dass ein Benutzer Zugang erlangt und ein oder mehrere Feldkabel im Feldkabelaufnahmehohlraum elektrisch mit dem Verbindungsblock verbindet;
**gekennzeichnet durch**
eine zwischen einer geschlossenen Stellung und einer geöffneten Stellung bewegbare Klappe (30), wobei die Klappe (30) in der geschlossenen Stellung an der Vorderseite des Feldkabelaufnahmehohlraums (50) entlangverläuft und den Feldkabelaufnahmehohlraum abdeckt.

2. Wandmontageverbinder nach Anspruch 1, wobei der Verbindungsblock Folgendes umfasst:
eine Gruppierung von Stiftanschlussklemmen (104), die konfiguriert ist, um eine Gruppierung von Stiften, die sich vom Thermostat nach hinten erstrecken, zu fassen; und
eine Gruppierung von Leitungsklemmen, wobei jede der Leitungsklemmen konfiguriert ist, um elektrisch mit einem entsprechenden Feldkabel verbunden zu werden.

3. Wandmontageverbinder nach Anspruch 1 oder Anspruch 2, wobei der Verbindungsblock konfiguriert ist, um in das Gehäuse einzurasten.

4. Wandmontageverbinder nach Anspruch 3, wobei der Verbindungsblock einen Befestigungsflansch (96) entlang einer Seite des Verbindungsblocks und eine oder mehrere Befestigungslaschen (98) entlang einer gegenüberliegenden zweiten Seite des Verbindungsblocks umfasst und das Gehäuse konfiguriert ist, um den Befestigungsflansch und die eine oder die mehreren Befestigungslaschen zu fassen, um den Verbindungsblock am Gehäuse zu befestigen.

5. Wandmontageverbinder nach einem der Ansprüche 1 bis 4, wobei die Klappe (30), wenn die Klappe in der geöffneten Stellung ist, von der Vorderseite des Feldkabelaufnahmehohlraums wegbewegt wird, um Benutzerzugang zum Feldkabelaufnahmehohlraum und zum Verbindungsblock zu gewähren.

6. Wandmontageverbinder nach einem der Ansprüche 1 bis 5, wobei die Klappe (30) über ein an oder nahe bei einem unteren Ende der Klappe platzierten Scharnier (60) am Gehäuse befestigt ist.

7. Wandmontageverbinder nach einem der Ansprüche 1 bis 6, wobei die Klappe (30) ferner eine an oder nahe bei einem oberen Ende der Klappe angeordnete Befestigung (66) umfasst, wobei die Befestigung konfiguriert ist, um die Klappe lösbar in der geschlossenen Stellung zu befestigen, und über eine Zusammenwirkung mit einem Werkzeug aus der geschlossenen Stellung lösbar ist.

8. Wandmontageverbinder nach Anspruch 2, wobei die Gruppierung von Leitungsklemmen eine erste Thermostatstromleitungsklemme, eine zweite Thermostatstromleitungsklemme und eine oder mehrere Sensorleitungsklemmen enthält.

9. Wandmontageverbinder nach Anspruch 2, wobei die Gruppierung von Leitungsklemmen mindestens eine Kommunikationsleitungsklemme und mindestens eine Sensorleitungsklemme enthält.

10. Wandmontageverbinder nach Anspruch 1, wobei der Verbindungsblock Folgendes umfasst:
einen ersten Verbindungsblock, der entlang einer Seite des Feldkabelaufnahmehohlraums positioniert ist, wobei der erste Verbindungsblock Folgendes umfasst:
eine erste Gruppierung von Stiftanschlussklemmen, die konfiguriert ist, um eine erste Gruppierung von Stiften, die sich vom Thermostat nach hinten erstrecken, zu fassen;
eine erste Gruppierung von Leitungsklemmen, wobei jede der ersten Gruppierung von Leitungsklemmen konfiguriert ist, um elektrisch mit einem entsprechenden Feldkabel verbunden zu werden;
einen zweiten Verbindungsblock, der entlang derselben Seite des Feldkabelaufnahmehohlraums positioniert und vom ersten Verbindungsblock vertikal beabstandet ist, wobei der zweite Verbindungsblock Folgendes umfasst:
eine zweite Gruppierung von Stiftanschlussklemmen, die konfiguriert ist, um eine zweite Gruppierung von Stiften, die sich vom Thermostat nach hinten erstrecken, zu fassen;
eine zweite Gruppierung von Leitungsklemmen, wobei jede der zweiten Gruppierung von Leitungsklemmen konfiguriert ist, um elektrisch mit einem entsprechenden Feldkabel verbunden zu werden; und
wobei die Klappe, wenn die Klappe in der geschlossenen Stellung ist, die erste Gruppierung von Leitungsklemmen und die zweite Gruppierung von Leitungsklemmen abdeckt, jedoch die erste Gruppierung von Stiftanschlussklemmen oder die zweite Gruppierung von Stiftanschlussklemmen nicht abdeckt.

11. Wandmontageverbinder nach Anspruch 10, wobei die Klappe (30) eine oder mehrere Öffnungen definiert, sodass die eine oder die mehreren Öffnungen, wenn die Klappe in der geschlossenen Stellung ist, an der ersten Gruppierung von Stiftanschlussklemmen und der zweiten Gruppierung von Stiftanschlussklemmen ausgerichtet sind und Zugang zur ersten Gruppierung von Stiftanschlussklemmen und zur zweiten Gruppierung von Stiftanschlussklemmen gewähren.

12. Wandmontageverbinder nach Anspruch 10 oder Anspruch 11, wobei der erste Verbindungsblock vertikal über dem zweiten Verbindungsblock ist und die erste Gruppierung von Leitungsklemmen eine Masseleitungsklemme (Common) für ein Relais und eine oder mehrere von einer Schließer-NO-Leitungsklemme (NO = Normally Open) und einer Öffner-NC-Leitungsklemme (NC = Normally Closed) enthält.

13. Wandmontageverbinder nach einem der Ansprüche 10 bis 12, wobei die zweite Gruppierung von Leitungsklemmen eine erste Thermostatstromleitungsklemme, eine zweite Thermostatstromleitungsklemme und eine oder mehrere Sensorleitungsklemmen enthält.

14. Wandmontageverbinder nach einem der Ansprüche 10 bis 12, wobei die zweite Gruppierung von Leitungsklemmen eine oder mehrere Kommunikationsleitungsklemmen und eine oder mehrere Sensorleitungsklemmen enthält.

15. Wandmontageverbinder nach einem der Ansprüche 10 bis 14, wobei das Gehäuse ferner eine Trennwand, die den Feldkabelaufnahmehohlraum in einen oberen Abschnitt für den Zugang zum ersten Verbindungsblock und einen unteren Abschnitt für den Zugang zum zweiten Verbindungsblock teilt, umfasst.

## Revendications

1. Connecteur montable sur paroi (14) pour fixer un thermostat à une paroi, le connecteur montable sur paroi (14) comprenant :
un boîtier (20) ayant une face avant (22) et une face arrière (24), la face arrière (24) est configurée pour être montable sur une paroi ;
le boîtier (20) définissant une cavité de réception de câble d'excitation (50) incluant une ouverture de câble d'excitation (52) s'étendant à travers la face arrière (24) du boîtier (20) et dans la cavité de réception de câble d'excitation (50) afin de recevoir un ou plusieurs fils d'excitation ;
un bloc de connexion positionné à côté de la cavité de réception de câble d'excitation (50), le bloc de connexion étant configuré pour se connecter électriquement à un ou plusieurs fils d'excitation ;
une face avant de la cavité de réception de câble d'excitation est ouverte pour permettre à un utilisateur d'obtenir un accès et de connecter électriquement un ou plusieurs fils d'excitation dans la cavité de réception de câble d'excitation au bloc de connexion ; **caractérisé par**
une porte (30) mobile entre une position fermée et une position ouverte, dans lequel, dans la position fermée, la porte (30) est située le long de la face avant de la cavité de réception de câble d'excitation (50) et couvre la cavité de réception de câble d'excitation.

2. Connecteur montable sur paroi selon la revendication 1, dans lequel le bloc de connexion comprend :
un groupement de bornes de broches (104) configuré pour loger un groupement de broches s'étendant vers l'arrière à partir du thermostat ; et
un groupement de bornes de câblage, avec chacune des bornes de câblage configurée pour se connecter électriquement à un fil d'excitation correspondant.

3. Connecteur montable sur paroi selon l'une quelconque des revendications 1 ou 2, dans lequel le bloc de connexion est configuré pour s'encliqueter dans le boîtier.

4. Connecteur montable sur paroi selon la revendication 3, dans lequel le bloc de connexion comprend une bride de fixation (96) le long d'une face du bloc de connexion et une ou plusieurs languettes de fixation (98) le long d'une seconde face opposée du bloc de connexion, et le boîtier est configuré pour loger la bride de fixation et les un ou plusieurs languettes de fixation afin de fixer le bloc de connexion au boîtier.

5. Connecteur montable sur paroi selon l'une quelconque des revendications 1 à 4, dans lequel, lorsque la porte (30) est dans la position ouverte, la porte est déplacée pour s'éloigner de la face avant de la cavité de réception de câble d'excitation pour fournir, à un utilisateur, l'accès à la cavité de réception de câble d'excitation et au bloc de connexion.

6. Connecteur montable sur paroi selon l'une quelconque des revendications 1 à 5, dans lequel la porte (30) est fixée au boîtier par l'intermédiaire d'une charnière (60) disposée au niveau ou près d'une extrémité inférieure de la porte.

7. Connecteur montable sur paroi selon l'une quelconque des revendications 1 à 6, dans lequel la porte (30) comprend en outre une fixation (66) située au niveau ou près d'une extrémité supérieure de la porte, la fixation étant configurée pour fixer, de façon libérable, la porte dans la position fermée, et est libérable de la position fermée par l'intermédiaire d'une interaction avec un outil.

8. Connecteur montable sur paroi selon la revendication 2, dans lequel le groupement de bornes de câblage inclut une première borne de câblage d'alimentation électrique de thermostat, une seconde borne de câblage d'alimentation électrique de thermostat, et une ou plusieurs bornes de câblage de capteur.

9. Connecteur montable sur paroi selon la revendication 2, dans lequel le groupement de bornes de câblage inclut au moins une borne de câblage de communication et au moins une borne de câblage de capteur.

10. Connecteur montable sur paroi selon la revendication 1, dans lequel le bloc de connexion comprend :
un premier bloc de connexion positionné le long d'une face de la cavité de réception de câble d'excitation, le premier bloc de connexion comprenant :
un premier groupement de bornes de broches configuré pour loger un premier groupement de broches s'étendant vers l'arrière à partir du thermostat ;
un premier groupement de bornes de câblage, chacune du premier groupement de bornes de câblage étant configurée pour se connecter électriquement à un fil d'excitation correspondant ;
un second bloc de connexion positionné le long de la même face de la cavité de réception de câble d'excitation et verticalement espacé du premier bloc de connexion, le second bloc de connexion comprenant :
un second groupement de bornes de broches configuré pour loger un second groupement de broches s'étendant vers l'arrière à partir du thermostat ;
un second groupement de bornes de câblage, chacune du second groupement de bornes de câblage étant configurée pour se connecter électriquement à un fil d'excitation correspondant ; et
dans lequel, lorsque la porte est dans la position fermée, la porte couvre le premier groupement de bornes de câblage et le second groupement de bornes de câblage mais ne couvre pas le premier groupement de bornes de broches ou le second groupement de bornes de broches.

11. Connecteur montable sur paroi selon la revendication 10, dans lequel la porte (30) définit une ou plusieurs ouvertures de telle sorte que, lorsque la porte est dans la position fermée, les une ou plusieurs ouvertures soient alignées avec le premier groupement de bornes de broches et le second groupement de bornes de broches, et fournissent un accès à ceux-ci.

12. Connecteur montable sur paroi selon l'une quelconque des revendications 10 ou 11, dans lequel le premier bloc de connexion est verticalement au-dessus du second bloc de connexion, et le premier groupement de bornes de câblage inclut une borne de câblage commune de relais, et un ou plusieurs d'une borne de câblage normalement ouverte, NO, et une borne de câblage normalement fermée, NC.

13. Connecteur montable sur paroi selon l'une quelconque des revendications 10 à 12, dans lequel le second groupement de bornes de câblage inclut une première borne de câblage d'alimentation électrique de thermostat, une seconde borne de câblage d'alimentation électrique de thermostat, et une ou plusieurs bornes de câblage de capteur.

14. Connecteur montable sur paroi selon l'une quelconque des revendications 10 à 12, dans lequel le second groupement de bornes de câblage inclut une ou plusieurs bornes de câblage de communication et une ou plusieurs bornes de câblage de capteur.

15. Connecteur montable sur paroi selon l'une quelconque des revendications 10 à 14, dans lequel le boîtier comprend en outre une paroi de division qui divise la cavité de réception de câble d'excitation en une partie supérieure pour accéder au premier bloc de connexion et une partie inférieure pour accéder au second bloc de connexion.
